**Europäisches Patentamt**

**European Patent Office**

**Office européen des brevets**

(11) Veröffentlichungsnummer: **0 038 551 B1**

(12) **EUROPÄISCHE PATENTSCHRIFT**

(45) Veröffentlichungstag der Patentschrift:
**16.01.85**

(51) Int. Cl.⁴: **G 01 R 29/14**, G 08 B 13/26, H 03 K 17/00

(21) Anmeldenummer: **81103007.1**

(22) Anmeldetag: **20.04.81**

(54) **Vorrichtung zur berührungslosen Bestimmung der Lage und/oder der dielektrischen Eigenschaften von Objekten.**

(30) Priorität: **18.04.80 DE 3014992**

(43) Veröffentlichungstag der Anmeldung:
**28.10.81 Patentblatt 81/43**

(45) Bekanntmachung des Hinweises auf die Patenterteilung:
**16.01.85 Patentblatt 85/3**

(84) Benannte Vertragsstaaten:
**AT BE CH DE FR GB IT LI NL SE**

(56) Entgegenhaltungen:
**CH - A - 290 757**
**CH - A - 549 204**
**US - A - 3 727 208**
**US - A - 4 199 715**

(73) Patentinhaber: **Fraunhofer-Gesellschaft zur Förderung der angewandten Forschung e.V., Leonrodstrasse 54, D-8000 München 19 (DE)**

(72) Erfinder: **Dumbs, Alfred, Dr-Ing.Dipl.-Phys., Fillibachstrasse 17, D-7800 Freiburg (DE)**
Erfinder: **Bergmann, Eckhard, Ing.grad., Engesserstrasse 1a, D-7800 Freiburg (DE)**

(74) Vertreter: **Rackette, Karl, Dipl.-Phys, Dr.-Ing, Kaiser-Joseph-Strasse 179 Postfach 1310, D-7800 Freiburg (DE)**

## Beschreibung

Die Erfindung betrifft eine Vorrichtung zur berührungslosen Bestimmung der Lage und/oder der dielektrischen Eigenschaften von Objekten mit einer an den Eingang einer Auswerteschaltung angekoppelten Messelektrode und mit einer ersten und einer zweiten felderzeugenden Elektrode, die mit Wechselspannungen beaufschlagt sind, deren Phasen gegeneinander um 180° verschoben sind.

Eine derartige Vorrichtung ist aus der US-A-3 727 208 bekannt und verfügt über zwei unmittelbar mit den Enden zweier Sekundärwicklungen eines Transformators verbundene felderzeugende Elektroden. Die zwischen den felderzeugenden Elektroden verlaufende Messelektrode ist mit dem ersten Eingang eines in der Auswerteschaltung vorgesehenen Operationverstärkers verbunden, dessen zweiter Eingang an die Mittelanzapfung der Sekundärwicklungen und eine Potentiometerschaltung angeschlossen ist. Mit Hilfe der Potentiometerschaltung wird die am zweiten Eingang des Operationsverstärkers liegende Spannung so verändert, dass bei Abwesenheit des zu erfassenden Objektes am Ausgang des Operationsverstärkers eine möglichst kleine Spannung anliegt. Mit Hilfe eines ersten Potentiometers wird die Amplitude und mit Hilfe eines zweiten Potentiometers die Phase justiert. Da auch bei Abwesenheit eines Objektes bereits beide Eingänge des Operationsverstärkers mit Spannungen beaufschlagt sind, ist der gesamte zur Verfügung stehende Eingangsspannungshub des Operationsverstärkers nicht voll ausnutzbar, womit ein Empfindlichkeitsverlust und ein Dynamikverlust verbunden sind. Da bei hohen Unsymmetrien in der Umgebung der felderzeugenden Elektroden hohe Kompensationsspannungen mit Hilfe der Potentiometerschaltungen eingestellt werden müssen, ist es nicht möglich, die bei der bekannten Vorrichtung im Erdboden verlegten Elektroden zur Lagebestimmung bspw. in einem Glühofen zu verwenden.

Der Erfindung liegt die Aufgabe zugrunde, eine Vorrichtung der eingangs genannten Art zu schaffen, die insbesondere eine Lagebestimmung in einem Glühofen gestattet und die auch im glühenden Zustand des durch die felderzeugenden Elektroden und die Messelektrode gebildeten Sensorteils funktionsfähig bleibt. Ausserdem soll eine Bestimmung der dielektrischen Eigenschaften und insbesondere eine Erfassung von Änderungen der dielektrischen Eigenschaften von Objekten durchführbar sein.

Diese Aufgabe wird erfindungsgemäss dadurch gelöst, dass eine der felderzeugenden Elektroden an eine erste mit einer Schaltung zur Amplitudenverstellung der Ausgangsamplitude versehenen Ausgangsstufe angeschlossen ist, wobei durch die Schaltung das Amplitudenverhältnis der Wechselspannungen auf den felderzeugenden Elektroden so veränderbar ist, dass bei Abwesenheit des zu erfassenden Objektes die in der Messelektrode durch die beiden felderzeugenden Elektroden bewirkten Ströme gegenseitig kompensiert sind.

Dadurch, dass die Spannungen an den felderzeugenden Elektroden und nicht eine Kompensationsspannung für einen Operationsverstärker veränderbar sind, kann bei der erfindungsgemässen Vorrichtung eine Messung des Stromes auf der Messelektrode gegen Null durchgeführt werden. Da die Amplituden auf den beiden felderzeugenden Elektroden so gewählt sind, dass bei Abwesenheit des zu erfassenden Objektes in der Messelektrode kein Strom auftritt und das Potential der Messelektrode Null ist, kann die Auswerteschaltung einen Operationsverstärker mit einem hohen Verstärkungsgrad aufweisen, um dadurch eine hohe Empfindlichkeit auch bei Unsymmetrien in der Elektrodenanordnung zu erzielen. Das Problem der Verwendbarkeit des Sensorteils der Vorrichtung im Ofen reduziert sich somit auf die Resistenz der drei Elektroden und deren Isolatoren gegen die hohe Temperatur der Umgebung. Eine Trennung zwischen dem aus den Elektroden gebildeten Sensorteil und der elektronischen Auswerteschaltung ist auf einfache Weise möglich, indem diese durch temperaturfeste Leitungen miteinander verbunden sind.

Bei einem bevorzugten Ausführungsbeispiel für die Glühofenanwendung sind die Elektroden als parallel zueinander verlaufende Stäbe ausgebildet, die in einer feuerfesten keramischen Masse eingebettet sind. Eine Beeinflussung der Fühlrichtungscharakteristik ist möglich, wenn wenigstens eine der Elektroden mit einer rinnenförmigen Abschirmung versehen ist. Dabei kann die Abschirmung beispielsweise U-förmig ausgebildet sein.

Dadurch, dass die Zuleitungen zu den Elektroden niederohmig ausgebildet sind, ist die Länge dieser Zuleitungen nur von sekundärer Bedeutung. Eine besonders hohe Genauigkeit und Empfindlichkeit werden erreicht, wenn die Messelektrode über einen Schmalbandverstärker mit dem Eingang eines phasenempfindlichen Gleichrichters verbunden ist. Langzeitdriften der Elektronik sowie Veränderungen des mechanischen Sensorteils durch Abbrand usw. werden mit Hilfe eines Nullpunktkorrekturschaltkreises eliminiert.

In der Zeichnung sind Ausführungsbeispiele des Gegenstandes der Erfindung dargestellt. Es zeigen:

Fig. 1 ein Schaltbild der erfindungsgemässen Vorrichtung zur Erläuterung des Messprinzips,

Fig. 2 den Potentialverlauf zwischen den felderzeugenden Elektroden,

Fig. 3 ein erstes Ausführungsbeispiel der Erfindung mit asymmetrisch angeordneten Elektroden,

Fig. 4 den Spannungsverlauf des Ausgangssignals der Auswerteschaltung,

Fig. 5 das Ausgangssignal der Auswerteschaltung bei symmetrisch angeordneten Elektroden,

Fig. 6 ein weiteres Ausführungsbeispiel der erfindungsgemässen Vorrichtung mit einem eine U-förmige Abschirmung aufweisenden Sensorteil und

Fig. 7 das Blockschaltbild eines Ausführungsbeispiels für eine Auswerteschaltung und die erforderlichen Wechselspannungsquellen.

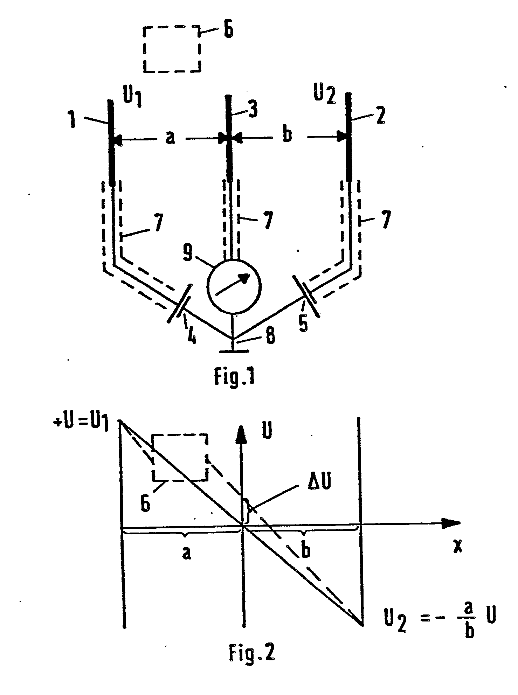

Zur Erläuterung des Messprinzips ist die erfindungsgemässe Vorrichtung in Fig. 1 schematisch dargestellt. Der Sensor der Vorrichtung verfügt über eine erste felderzeugende Elektrode 1 und eine zweite felderzeugende Elektrode 2, zwischen denen eine Messelektrode 3 angeordnet ist. Die Abstände a und b zwischen der Messelektrode 3 und den felderzeugenden Elektroden 1, 2 sind bei dem in Fig. 1 dargestellten Beispiel gleich. Die felderzeugenden Elektroden 1, 2 werden aus einer ersten Spannungsquelle 4 und einer zweiten Spannungsquelle 5 versorgt. Dabei sind die Spannungen so gewählt, dass das Potential an der Stelle der Messelektrode 3 bei Abwesenheit des zu erfassenden Objektes 6, das beispielsweise ein Werkstück sein kann, Null ist. Um den Ort der Sensibilität des Sensor festzulegen, sind die Verbindungsleitungen der felderzeugenden Elektroden 1, 2 und der Messelektrode 3 mit Abschirmungen 7 versehen. Die Abschirmungen 7 sowie die nicht mit den felderzeugenden Elektroden 1, 2 verbundenen Pole der Spannungsquellen 4, 5 sind mit der Masse 8 in Verbindung.

Ein Elektrometer 9 dient zur Anzeige des von der Messelektrode 3 erfassten Potentials. Das von den felderzeugenden Elektroden 1, 2 erzeugte elektrische Feld ist ein Gleichfeld, wenn die erste Spannungsquelle 4 und die zweite Spannungsquelle 5 zwei gegensinnig gepolte Gleichspannungsquellen sind. Um die Sonde zur Messung des Potentials mechanisch einfach gestalten zu können und eine empfindliche sowie störungsarme Messung zu gestatten, ist die Erzeugung eines Wechselfeldes mit starrer Frequenz vorteilhaft. Die erste Spannungsquelle 4 und die zweite Spannungsquelle 5 sind dann Wechselspannungsquellen, deren Phasenlagen sich um 180° voneinander unterscheiden. Das Elektrometer 9 dient im Falle eines Wechselfeldes zur Anzeige eines Stromes, der bei Abwesenheit des zu messenden Objektes 6 infolge der Phasenlagen bei gleichen Amplituden und symmetrischer Anordnung der Messelektrode 3 zu den felderzeugenden Elektroden 1, 2 Null ist.

In Fig. 2 ist der Potentialverlauf zwischen der ersten felderzeugenden Elektrode 1 mit der Spannung $U_1 = +U$ und der zweiten felderzeugenden Elektrode 2 mit der Spannung $U_2 = -a/b \times U$ dargestellt. Im Falle gleicher Abstände a und b sind die Spannungen $U_1$ und $U_2$ dem Betrag nach gleich, wobei am Ort der Messelektrode 3 das Potential Null herrscht, wie aus der durchgezogenen Linie in Fig. 2 erkennbar ist.

Wird nun ein Objekt 6 in das durch die Elektroden 1, 2 erzeugte Feld an einer zur Messelektrode 3 unsymmetrisch gelegenen Stelle ausserhalb der Fläche des Potentials Null eingebracht und unterscheidet sich die Dielektrizitätskonstante des Objektes 6 von der Umgebung, so bewirkt die Änderung der Feldverteilung durch das Objekt 6 eine Potentialverschiebung $\Delta U$ an der Stelle der Messelektrode 3, wie in Fig. 2 gestrichelt veranschaulicht ist. Das Vorzeichen der Verschiebung beziehungsweise die Phasenlage gestattet es festzustellen, auf welcher Seite der Messelektrode 3 sich das Objekt 6 im Gleichfeld bzw. Wechselfeld befindet. Der Betrag der Potentialverschiebung $\Delta U$ bzw. die Amplitude des Wechselstromes ist ein Mass für den Abstand des Objektes 6 von einem definierten Punkt oder einer Ebene des Sensors, wobei diese Bezugsorte von der Formgebung des Sensors abhängen.

Die Länge der elektrischen Zuleitungen zu den Elektroden 1, 2 und der Messelektrode 3 ist nur von sekundärer Bedeutung. Die Zuleitungen für die Elektroden und die Spannungsquellen sind vorzugsweise niederohmig ausgeführt, so dass Blindströme die Signale kaum beeinflussen. Da die Influenzeffekte auf der Messelektrode 3 als Strom nachgewiesen werden, der auf einer niederohmigen Leitung praktisch keinen Potentialabfall bewirkt, sind auch kapazitive Verluste vernachlässigbar klein. Weil in Abwesenheit des zu messenden Objektes 6 die Bezugsgrösse jeweils der Messelektrodenstrom = Null ist, ergibt sich die Möglichkeit, Langzeitdriften der an den Sensor angeschlossenen Elektronik und Veränderungen des mechanischen Sensorteils, wie Temperaturverzüge, Abbrand, Veränderungen der Umwelt usw., elektrisch zu eliminieren und zwar durch Regelung der Amplitude der Spannung einer der felderzeugenden Elektroden 1, 2 in der Weise, dass der Messelektrodenstrom zu Null wird.

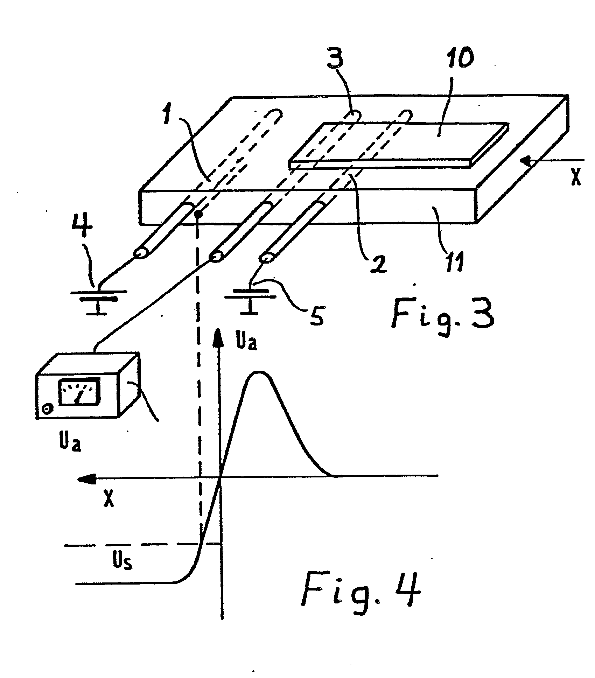

Fig. 3 zeigt ein Ausführungsbeispiel der erfindungsgemässen Vorrichtung, bei dem die Abstände a, b zwischen der Messelektrode 3 und den felderzeugenden Elektroden 1, 2 ungleich sind. Die felderzeugenden Elektroden 1, 2 werden über Zuleitungen, die mit Abschirmungen versehen sind, von zwei Spannungsquellen 4, 5 versorgt, die jeweils eine Wechselspannung mit einer Frequenz von vorzugsweise 10 KHz bis etwa 50 KHz liefern. Die Phasen der beiden Spannungsquellen 4, 5 sind um 180° verschoben. Entsprechend den Abstandsverhältnissen ist die Amplitude der ersten Spannungsquelle 4 grösser als die Amplitude der zweiten Spannungsquelle 5, so dass bei Abwesenheit der Palette 10 kein Strom in der Messelektrode 3 fliesst.

Bei der Anordnung gemäss Fig. 3 sind die felderzeugenden Elektroden 1, 2 sowie die Messelektrode 3 in eine Unterlage 11 aus Schamotte eingebettet, die als feuerfeste Auflage für die in die X-Richtung verschiebbare Palette 10 dient.

In Fig. 4 ist der Spannungsverlauf dargestellt, der sich durch phasenempfindliches Gleichrichten des Stromes in der Messelektrode 3 durch eine Auswerteschaltung oder ein Messgerät 12 ergibt, an dessen Eingang die Messelektrode 3 über eine beliebig lange niederohmige abgeschirmte Leitung angeschlossen ist. Wie man in Fig. 4 erkennt, steigt beim Annähern der Palette 10 an den Sensor das Ausgangssignal $U_a$ des Messgerätes 12 zunächst an und geht dann bei weiterem Annähern der Palette 10 durch Null, bevor es mit umgekehrter Polarität wieder grösser wird. Infolge der unsymmetrischen Anordnung der Elektroden 1, 2, 3 zeigt das Messgerät 12 auch dann einen Ausschlag, wenn die Palette 10 die Anordnung der Elektroden 1, 2, 3 gleichmässig überdeckt.

Durch Vergleich der Ausgangsspannung $U_a$ mit einer Schwellenspannung $U_s$ ist eine exakte Positionsvermessung der Palette 10 bzw. deren Vorderkante möglich. Die gestrichelte Linie zwischen den Fig. 3 und 4 deutet die beim Erreichen des Schwellenwertes $U_s$ von der Vorderkante der Palette eingenommene Lage an.

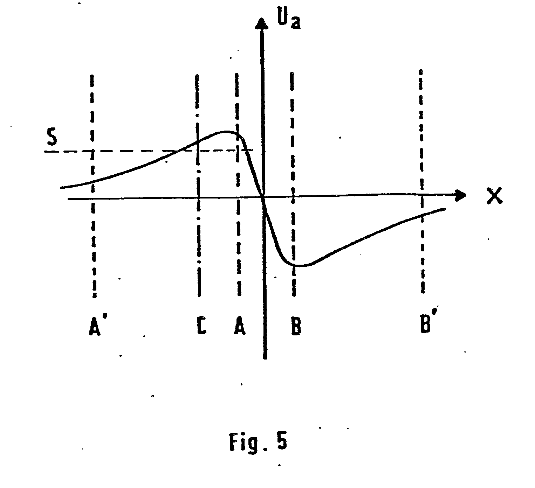

Bei einer symmetrischen Anordnung der felderzeugenden Elektroden 1, 2 in Bezug auf die Messelektrode 3 ergibt sich der in Fig. 5 dargestellte Verlauf der Ausgangsspannung $U_a$, wenn ein Objekt 6 sich dem Erfassungsbereich von der Seite der ersten felderzeugenden Elektrode 1 nähert und diesen auf der Seite der zweiten felderzeugenden Elektrode 2 wieder verlässt. Die Reichweite des Sensors kann in Abhängigkeit von den geometrischen Abmessungen und Spannungsamplituden einige Millimeter bis mehrere Meter sein. Das Abstandsgesetz ist dabei abhängig von der Sensorform. Für eine Mittigkeitsmessung ($U_a = 0$) wird der Bereich zwischen A und B in Fig. 5 ausgenutzt. Wenn es auf extreme Nichtlinearität nicht ankommt, ist der Bereich zwischen A' und B' verwendbar. Bei Abstandmessungen wird ein Schwellenwert S als Indikator für den richtigen Abstand benutzt. Um Mehrdeutigkeiten zu vermeiden ist der Bereich rechts von C für das Objekt 6 im allgemeinen verboten und zwar durch Vorgabe des Bewegungsablaufes oder durch Anbringen einer Feld-Abschirmung, die gleichzeitig eine zu starke Annäherung des Objektes 6 an die Null-Potential-Ebene des Sensor verhindert.

Die felderzeugenden Elektroden 1, 2 können mit in der Zeichnung nicht dargestellten rinnenförmigen Abschirmblechen versehen sein, um durch die auf diese Weise bewirkte Änderung der Feldverteilung die «Fühlrichtung» des aus den Elektroden 1, 2, 3 gebildeten Sensors festzulegen. Das Feld greift nur an der Stelle der offenen Abschirmung in den Raum hinaus, so dass nur in diesem Bereich ein Gegenstand erfasst werden kann.

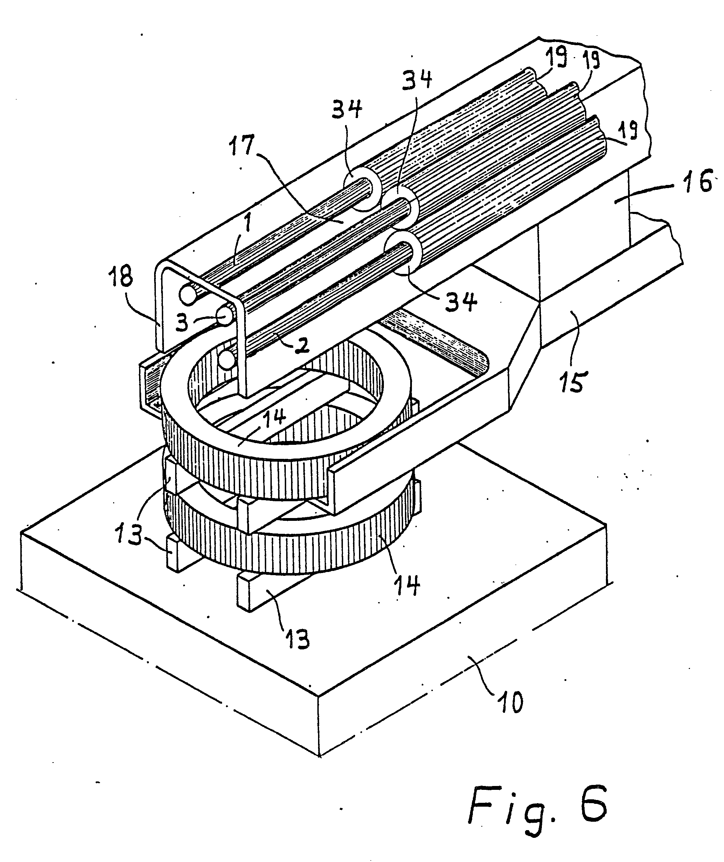

In Fig. 6 ist ein Ausführungsbeispiel der erfindungsgemässen Vorrichtung dargestellt, bei dem das Ausgangssignal $U_a$ keinen Nulldurchgang zwischen positiven und negativen Werten macht. Die in Fig. 6 sichtbare Palette 10 befindet sich in einem Aufkohlungsofen und trägt unter Einsatz mehrerer Abstandshalter 13 verschiedene auf Distanz gestapelte Zahnkränze 14. Die Zahnkränze 14 können mit Hilfe einer Gabel 15 von oben einzeln abgehoben und entnommen werden. Auf der Gabel 15 ist über ein Abstandsstück 16 ein Sensor 17 befestigt, mit dessen Hilfe das Annähern der Gabel 15 an die Zahnkränze 14 berührungslos erfasst werden kann.

Der Sensor 17 ist mit einem U-förmigen metallischen Abschirmprofil 18 versehen, in dessen Bodennähe die Messelektrode 3 und die erste felderzeugende Elektrode 1 angeordnet sind. Die zweite felderzeugende Elektrode 2 ist diagonal gegenüber der ersten felderzeugenden Elektrode 1 angeordnet. Die Elektroden 1, 2, 3 sind als mechanisch stabile Stäbe ausgebildet, die durch hülsenförmige Keramikisolatoren 34 auf Abstand gegenüber festen Abschirmrohren 19 gehalten werden.

Das U-förmige metallische Abschirmprofil 18 verursacht eine Feldabschirmung nach oben, so dass der Sensor 17 nach oben «blind» ist und von der Decke des Aufkohlungsofens nicht beeinflusst wird. Da das durch die felderzeugenden Elektroden 1, 2 erzeugte Feld jedoch nach unten und vorne austreten kann, ist der Sensor 17 in der Lage, die Oberkante der Zahnkränze 14 berührungslos zu bestimmen.

Um die mechanische Festigkeit der Anordnung zu erhöhen, sind die Elektroden 1, 2, 3 in einer feuerfesten, elektrisch nichtleitenden Masse eingebettet. Die Verwendbarkeit des Sensors 17 im Ofen ist lediglich von der Resistenz der drei Elektroden 1, 2, 3 und des Isolators gegen die hohe Temperatur der Umgebung abhängig. Der Sensor 17 und das zugehörige Messgerät 12 sind örtlich trennbar und durch ebenfalls temperaturfeste niederohmige abgeschirmte Leitungen verbunden.

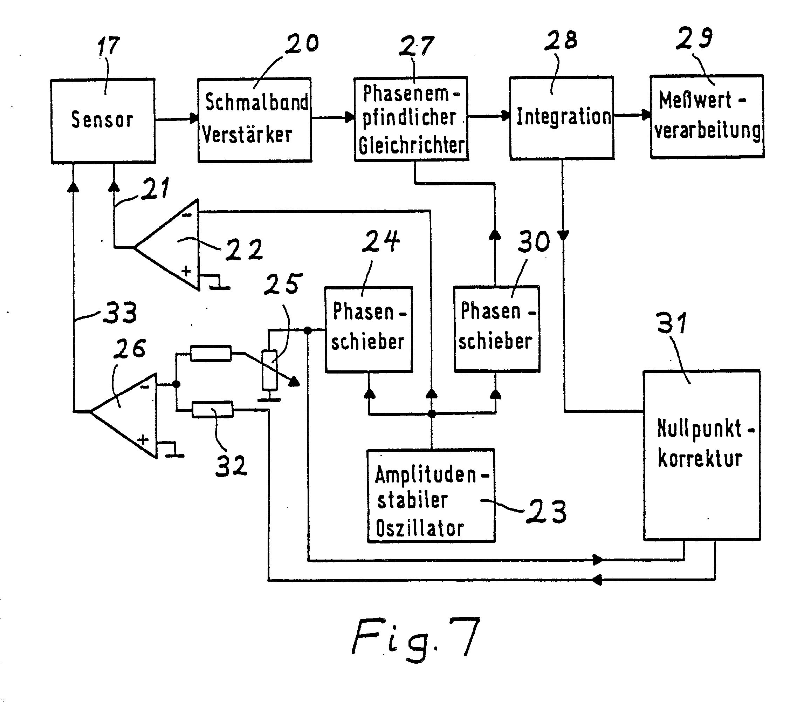

Ein Ausführungsbeispiel für die Spannungsquellen 4, 5 und das Messgerät 12 ist in Fig. 7 veranschaulicht. Der symmetrisch oder unsymmetrisch aufgebaute Sensor 17 ist mit seiner Messelektrode 3 an den niederohmigen Eingang eines schmalbandigen Verstärkers 20 angeschlossen. Der Durchlassbereich des Verstärkers 20 ist auf die Frequenz der den felderzeugenden Elektroden 1, 2 zugeführten Wechselspannung abgestimmt. Die erste felderzeugende Elektrode 1 ist über eine abgeschirmte Leitung 21 an den Ausgang einer zweiten Ausgangsstufe 22 angeschlossen, über die sie mit einer Wechselspannung versorgt wird, deren Frequenz einige 10 KHz beträgt. Der Eingang der Ausgangsstufe 22 wird von einem amplitudenstabilen Oszillator 23 gespeist. Der Oszillator 23 speist ausserdem über einen ersten Phasenschieber 24 oder Inverter und eine Potentiometerschaltung 25 zur manuellen Amplitudeneinstellung eine erste Ausgangsstufe 26, deren Ausgang mit der zweiten felderzeugenden Elektrode 2 des Sensors 17 über eine Leitung 33 in Verbindung steht. Durch Verändern der Einstellung der Potentiometerschaltung 25 wird das elektrische Wechselfeld des Sensors 17 in Abwesenheit des zu erfassenden Objektes 6 so eingestellt, dass das mit Hilfe eines an den Ausgang des Verstärkers 20 angeschlossenen phasenempfindlichen Gleichrichters 27 und einer Integrationsstufe 28 erhaltene Ausgangssignal $U_a$, das als Eingangssignal einer Messwertverarbeitungsschaltung 29 dient, Null wird. Der phasenempfindliche Gleichrichter 27 erhält als Referenzsignal über einen zweiten Phasenschieber 30 das Signal des Oszillators 23. Wenn nach der Nullpunktsabstimmung das zu messende Objekt 6 die Feldverteilung im Sensor 17 verändert, entsteht am Ausgang des Gleichrichters 27 ein Signal, dessen Amplitude dem Abstand und dessen Polarität der Richtung der Annäherung an den Sensor 17 zugeordnet ist.

Bei dem in Fig. 7 dargestellten Ausführungsbeispiel ist neben einer manuellen Nullpunktskorrektur ein selbsttätig arbeitender Nullpunktskorrekturschaltkreis 31 vorgesehen. Durch den Nullpunktskorrekturschaltkreis 31 wird ein Bruchteil des Ausgangssignals des Phasenschiebers 24 dem Eingang der Ausgangsstufe 26 über einen Widerstand 32 phasengleich hinzuaddiert. Liegt die bipolare Ausgangsspannung der Integrationsstufe 28 oberhalb einer positiven oder negativen Schwellspannung, werden mit Hilfe einer Torschaltung und eines Taktgenerators Impulse einem Vor/Rückwärtszähler zugeführt. Der Taktgenerator erzeugt dabei nur so lange Impulse wie eine manuell betätigbare Korrekturtaste gedrückt wird. Der Ausgang des Vor/Rückwärtszählers speist einen Digital-Analog-Wandler, an dessen Referenzspannungseingang die Wechselspannung des Phasenschiebers 24 angeschlossen ist. Die Ausgangsspannung des Digital-Analog-Wandlers ist somit eine Wechselspannung. Eine Korrektur der Wechselspannungsamplitude erfolgt also immer dann, wenn ein Schwellenwert überschritten ist und die Korrekturtaste gedrückt worden ist.

**Patentansprüche**

1. Vorrichtung zur berührungslosen Bestimmung der Lage und/oder der dielektrischen Eigenschaften von Objekten mit einer an den Eingang einer Auswerteschaltung (20, 27, 28, 29) angekoppelten Messelektrode (3) und mit einer ersten (1) und einer zweiten (2) felderzeugenden Elektrode (1, 2), die mit Wechselspannungen (4, 5, 21, 33) beaufschlagt sind, deren Phasen gegeneinander um 180° verschoben sind, dadurch gekennzeichnet, dass eine der felderzeugenden Elektroden (1, 2) an eine erste mit einer Schaltung (25; 31, 32) zur Amplitudenverstellung der Ausgangsamplitude versehenen Ausgangsstufe (26) angeschlossen ist, wobei durch die Schaltung (25; 31, 32) das Amplitudenverhältnis der Wechselspannungen (4, 5, 21, 33) auf den felderzeugenden Elektroden (1, 2) so veränderbar ist, dass bei Abwesenheit des zu erfassenden Objektes (6) die in der Messelektrode (3) durch die beiden felderzeugenden Elektroden (1, 2) bewirkten Ströme gegenseitig kompensiert sind.

2. Vorrichtung nach Anspruch 1, dadurch gekennzeichnet, dass die Schaltung zur Amplitudenverstellung ein am Eingang der ersten Ausgangsstufe (26) liegendes Potentiometer (25) ist.

3. Vorrichtung nach Anspruch 1 oder 2, dadurch gekennzeichnet, dass die erste felderzeugende Elektrode (1) an eine niederohmige durch einen amplitudenstabilen Oszillator (23) angesteuerte zweite Ausgangsstufe (22) und die zweite felderzeugende Elektrode (2) an die erste Ausgangsstufe (26) angeschlossen ist, die ebenfalls niederohmig ist und mit dem amplitudenstabilen Oszillator (23) über einen Phasenschieber (24) sowie die Schaltung (25; 31, 32) zur Amplitudenverstellung verbunden ist.

4. Vorrichtung nach Anspruch 3, dadurch gekennzeichnet, dass die Messelektrode (3) über einen auf die Oszillatorfrequenz abgestimmten eingangsseitig niederohmigen Schmalbandverstärker (20) mit dem Eingang eines phasenempfindlichen Gleichrichters (27) verbunden ist, der mit dem Ausgangssignal des Oszillators (23) über einen Kompensations-Phasenschieber (30) als Referenzsignal beaufschlagt ist.

5. Vorrichtung nach Anspruch 4, dadurch gekennzeichnet, dass das Ausgangssignal des phasenempfindlichen Gleichrichters (27) an den Eingang einer Integrationsstufe (28) angeschaltet ist, die eine Messwertverarbeitungsschaltung (29) sowie einen eine Korrekturtaste aufweisenden Nullpunktskorrekturschaltkreis (31) speist, mit dessen Hilfe die Amplitude der der ersten Ausgangsstufe (26) für die zweite felderzeugende Elektrode (2) zugeführten Spannung (5) veränderbar ist, bis das Ausgangssignal der Integrationsstufe (28) Null ist.

6. Vorrichtung nach einem der vorstehenden Ansprüche, dadurch gekennzeichnet, dass die felderzeugenden Elektroden (1, 2) sowie die Messelektrode (3) als parallel zueinander verlaufende Stäbe ausgebildet sind, die mit geerdeten abgeschirmten Zuleitungen (7) versehen sind.

7. Vorrichtung nach einem der Ansprüche 1 bis 6, dadurch gekennzeichnet, dass die felderzeugenden Elektroden (1, 2) und die Messelektrode (3) in einer feuerfesten keramischen Masse eingebettet sind.

8. Vorrichtung nach einem der Ansprüche 1 bis 7, dadurch gekennzeichnet, dass wenigstens eine der Elektroden (1, 2, 3) mit einer rinnenförmigen Abschirmung versehen ist.

9. Vorrichtung nach einem der Ansprüche 1 bis 8, dadurch gekennzeichnet, dass die Elektroden (1, 2, 3) gemeinsam in einer U-förmigen Abschirmung (18) angeordnet sind.

10. Vorrichtung nach Anspruch 9, dadurch gekennzeichnet, dass die Messelektrode (3) und eine felderzeugende Elektrode (1) in der Nähe des Bodens des U-förmigen Abschirmprofils (18) angeordnet sind und dass die zweite felderzeugende Elektrode (2) diagonal gegenüber der ersten felderzeugenden Elektrode (1) liegt.

**Claims**

1. A device for contactless determination of the position and/or dielectric properties of objects, the device comprising a measuring electrode (3), connected to the inlet of an evaluation circuit (20, 27, 28, 29) and a first (1) and a second (2) field-producing electrode which are loaded by alternating voltages (4, 5, 21, 33) the phases of which are displaced through 180° with respect to each other, characterised in that one of the field-producing electrodes (1, 2) is connected to a first outlet step (26) provided with a circuit (25; 31, 32) for the displacement of the output amplitude, the amplitude ratio of the alternating voltages (4, 5, 21, 33) on the field-producing electrodes (1, 2) being so changeable by the circuit (25; 31, 32) that in the absence of the object (6) to be registered the currents caused in the measuring electrode (3) by the two field-producing electrodes (1, 2) compensate each other.

2. A device according to Claim 1 characterised in that the circuit for amplitude displacement is a potentiometer (25) situated at the inlet of the first outlet step (26).

3. A device according to Claim 1 or 2 characterised in that the first field-producing electrode (1) is connected to a low-ohmic second outlet step (22) controlled by an amplitude-stable oscillator (23), and the second field-producing electrode (2) is connected to the first outlet step (26) which is also low-ohmic and is connected with the amplitude-stable oscillator (23) via a phaseshifter (24) and the circuit (25; 31, 32) for amplitude displacement.

4. A device according to Claim 3 characterised in that the measuring electrode (3) is connected to the inlet of a phase-sensitive rectifier (27) via a narrow band amplifier (20) which is low-ohmic on the inlet side and is tuned to the oscillator frequency, the rectifier being loaded by the output signal of the oscillator (23), acting as a reference signal, by a compensation phase shifter (30).

5. A device according to Claim 4 characterised in that the outlet signal of the phase-sensitive rectifier (27) is connected to the inlet of an integration step (28) which feeds a circuit (29) for processing the measuring value and a zero point correction circuit (31) provided with a correction key, by means of which can be varied the amplitude of the voltage (5) supplied to the first outlet step (26) for the second field-producing electrode (2), until the outlet signal of the integration step (28) equals zero.

6. A device according to any one of the preceding claims characterised in that the field-producing electrodes (1, 2) and also the measuring electrode (3) are in the form of mutually parallel rods provided with earthed screened feed lines (7).

7. A device according to any one of Claims 1 to 6, characterised in that the field-producing electrodes (1, 2) and the measuring electrode (3) are embedded in a heat-resistant ceramic material.

8. A device according to any one of Claims 1 to 7 characterised in that at least one of the electrodes (1, 2, 3) is provided with a trough-shaped screen.

9. A device according to any one of Claims 1 to 8, characterised in that the electrodes (1, 2, 3) are arranged together in a U-shaped screen (18).

10. A device according to Claim 9 characterised in that the measuring electrode (3) and a field-producing electrode (1) are arranged in the vicinity of the bottom of the U-shaped screening profile (18) and that the second field-producing electrode (2) extends diagonally relative to the first field-producing electrode (1).

**Revendications**

1. Dispositif pour la détermination sans contact de la position et/ou des propriétés diélectriques des objets présentant une électrode de mesure (3) reliée à l'entrée d'un circuit d'évaluation (20, 27, 28, 29) et une première (1) et une deuxième (2) électrodes génératrices de champ chargées en tensions alternatives (4, 5, 21, 33) dont les phases sont décalées les unes contre les autres de 180°, caractérisé en ce que l'une des électrodes (1, 2) génératrices de champ est raccordée à un premier étage de sortie (26) muni d'un circuit (25, 31, 32) pour régler les amplitudes de sortie, le rapport des amplitudes des tensions alternatives (4, 5, 21, 33) par rapport aux électrodes (1, 2) génératrices de champ peut être modifié par le circuit (25, 31, 32) de telle manière qu'en l'absence de l'objet (6) à retenir, les deux courants produits par les deux électrodes (1, 2) génératrices de champ dans l'électrode de mesure (3) sont compensés de façon réciproque.

2. Dispositif selon la revendication 1, caractérisé en ce que le circuit pour régler les amplitudes est un potentiomètre (25) placé à l'entrée du premier étage de sortie (26).

3. Dispositif selon la revendication 1 ou 2, caractérisé en ce que la première électrode (1) génératrice de champ est raccordée à un deuxième étage de sortie (22) de basse impédance commandé par un oscillateur (23) résistant aux amplitudes et la deuxième électrode (2) génératrice de champ au premier étage qui est également de basse impédance et relié à l'oscillateur (23) résistant aux amplitudes, par un déphaseur (24) ainsi que le circuit (25, 31, 32) pour régler les amplitudes.

4. Dispositif selon la revendication 3, caractérisé en ce que l'électrode de mesure (3) est reliée par un amplificateur à bandes étroites (20) de basse impédance côté entrée réglé sur la fréquence de l'oscillateur à l'entrée d'un redresseur de courant (27) sensible aux phases qui est chargé avec le signal de sortie de l'oscillateur (23) par un déphaseur de compensation (30) en tant que signal de référence.

5. Dispositif selon la revendication 4, caractérisé en ce que le signal de sortie du redresseur de courant (27) sensible aux phases est relié à l'entrée d'un étage d'intégration (28) qui alimente un circuit de traitement de valeurs mesurées (29) ainsi qu'un circuit de réglage à zéro (31) présentant une touche correction, à l'aide duquel l'amplitude de la tension (5) amenée au premier étage de sortie (26) pour la deuxième électrode (2) génératrice de champ peut être modifiée jusqu'à ce que le signal de sortie de l'étage d'intégration (28) est à zéro.

6. Dispositif selon l'une des revendications précédentes, caractérisé en ce que les électrodes (1, 2) génératrices de champ ainsi que l'électrode de mesure (3) sont réalisées en tant que barres parallèles entre elles munies de conducteurs protégés (7) mis à terre.

7. Dispositif selon l'une des revendications 1 à 6, caractérisé en ce que les électrodes (1, 2) génératrice de champ et l'électrode de mesure (3) sont incorporées dans une masse céramique réfractaire.

8. Dispositif selon l'une des revendications 1 à 7, caractérisé en ce qu'au moins une des électrodes (1, 2, 3) est munie d'un écran en forme de cuvette.

9. Dispositif selon l'une des revendications 1 à 8, caractérisé en ce que les électrodes (1, 2, 3) sont mises en place ensemble dans un écran (18) en forme de U.

10. Dispositif selon la revendication 9, caractérisé en ce que l'électrode de mesure (3) et une électrode (1) génératrice de champ sont mises en place près du fond du profilé (18) formant écran en forme de U et que la deuxième électrode (2) génératrice de champ est située diagonalement à l'opposée de la première électrode (1) génératrice de champ.

Fig.1

$$U_2 = - \frac{a}{b} U$$

Fig.2

Fig. 3

Fig. 4

Fig. 5

*Fig. 6*

Fig. 7